(19) Europäisches Patentamt
European Patent Office
Office européen des brevets

(11) **EP 4 621 457 A1**

(12) **EUROPEAN PATENT APPLICATION**

(43) Date of publication:
**24.09.2025 Bulletin 2025/39**

(21) Application number: **24164535.7**

(22) Date of filing: **19.03.2024**

(51) International Patent Classification (IPC):
**G02B 6/26** *(2006.01)*        **G01M 11/00** *(2006.01)*

(52) Cooperative Patent Classification (CPC):
**G02B 6/262; G01M 11/3154**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Keystone Photonics GmbH
76185 Karlsruhe (DE)**

(72) Inventors:
• **Dietrich, Philipp-Immanuel
  76744 Wörth (DE)**
• **Rupp, Florian
  76185 Karlsruhe (DE)**

(74) Representative: **Altmann Stößel Dick
Patentanwälte PartG mbB
Theodor-Heuss-Anlage 2
68165 Mannheim (DE)**

(54) **AN OPTICAL PROBE AND RELATED METHODS**

(57) The present invention relates to optical coupling between optical components and, more particular, to an optical probe (1) configured for optical testing of at least one micro-optical component (50), to a method for producing an optical probe (1), and to a method for optical testing of at least one micro-optical component (50). The optical probe (1) is comprising:
- a probe head (10), wherein the probe head (10) comprises a test component (2);
- at least one micro-optical element (20), wherein the micro-optical element (20) is a separate element with regard to the test component (2) and in mechanical contact with the test component (2),
wherein the micro-optical element (20) is configured to optically couple light (3) between the test component (2) and the micro-optical component (50), thereby being configured to determine an optical performance of the micro-optical component (50), and wherein the micro-optical element (20) is configured to be operated in an index matching liquid (17).

Fig. 1

EP 4 621 457 A1

## Description

Field of the invention

The present invention relates to optical coupling between optical components and, more particular, to an optical probe configured for optical testing of at least one micro-optical component and its use, to a method for producing an optical probe, and to a method for optical testing of at least one micro-optical component.

In particular, the optical probe can be used for fabrication, calibration, testing, and preselection of micro-optical components, which are particularly configured for optical communication, sensor applications, medical sensors, automotive applications, quantum applications, or environmental sensing; however, using the optical probe in other applications is also possible.

Related art

Optical probes which are configured for optically coupling to photonic integrated circuits featuring 3D-printed optics on fiber arrays are known. Further known are 3D-printed optics for optical packaging. Still further known are 3D-printed freeform probes for beam shaping of light exiting photonic integrated circuits. Still further known are optical probes by using an index matching liquid between the optical probe and an integrated photonic circuit.

WO 2018/083191 A1 discloses a fabrication of micro-optics for beam expansion on photonic integrated circuits for optical packaging.

US 6925238 B2 discloses using an index matching material in a probing procedure in order to reduce reflection.

Trappen M. et al. "3D-printed optical probes for wafer-level testing of photonic integrated circuits," Optics Express 28, 37996-38007, 2020, discloses 3D-printed optics on fiber arrays for probing wafers by inserting a 3D-printed micro-optics consisting of a mirror and a lens into an etched trench into a wafer.

Qu et al., "Experiments on Metamaterials with Negative Effective Static Compressibility," Phys. Rev. X 7, 041060, 2017, a procedure for producing air concealing hollow structures.

Peng et al., "CMOS Compatible Monolithic Fiber Attach Solution with Reliable Performance and Self-alignment," OFC, Th 3 1.4, 2022, describes photonic coupling interfaces which are designed to be operated in an index matching liquid.

Problem to be solved

It is therefore an objective of the present invention to provide an optical probe configured for optical testing of at least one micro-optical component and its use, a method for producing an optical probe, and a method for optical testing of at least one micro-optical component, which at least partially overcome the above-mentioned problems of the state of the art.

It is a particular objective of the present invention to provide an optical probe and a method configured for optical testing of components on die, batch, and wafer level. Preferably, the optical probe should have a compact probe head that can be inserted and probe in a trench of a wafer, wherein the trench may, preferably, 250 $\mu$m or less, more preferred 100 $\mu$m or less, especially 80 $\mu$m or less. Further, the optical probe should be configured for a small pitch, preferably of 127 $\mu$m or less, more preferred of 80 $\mu$m or less, especially of 50 $\mu$m or less, especially down to 20 $\mu$m. Herein, having a low pitch accuracy of three sigma = 1000 nm or less and a low mode-field size variation of one sigma = 10% or less would, particularly, be preferred.

Further, the optical probe should be configured for a high port count, preferably of at least 24, more preferred of at least 64, especially of at least 128. Preferably, a small mode-field, preferably of 10 $\mu$m or less, more preferred of 5 $\mu$m or less, especially twice an operation wavelength or less, should be available at a coupling location of the test component. Further, a calibration of probe variations shall be possible, e.g. by a test chip comprising waveguides having a known performance, wherein the test chip is located on a wafer chuck. The optical probe should be configured for robust probing even at high working distances, preferably at least 10 $\mu$m, more preferred at least 20 $\mu$m, in particular at least 40 $\mu$m. In addition, achieving a high testing throughput would be preferred, e.g. by probing at lest two, preferably a plurality of, channels at the same time.

It is particularly desirous if the optical probe is configured for working in the near ultraviolet range, the visual range, the near infrared range, and the medium infrared range, referring to a wavelength range of 100 nm to 10 $\mu$m, preferably of 200 nm to 4 $\mu$m, more preferred 530 nm to 2.7 $\mu$m, especially at least 1250 nm to 1650 nm. A high reproducibility of the optical coupling between the probe head and the at least one micro-optical component with variations of 0.5 dB or less, more preferred of 0.25 dB or less would be preferred both for coupling a single channel and for coupling light from multiple channels simultaneously without realignment of the probe for the individual channels.

Summary of the invention

This problem is solved by an optical probe configured for optical testing of at least one micro-optical component, a method for producing an optical probe, and a method for optical testing of at least one micro-optical component having the features of the independent claims. Preferred embodiments, which might be implemented in an isolated fashion or in any arbitrary combination, are listed in the dependent claims and throughout the following description.

In a first aspect, the present invention relates to an optical probe configured for optical testing of at least one micro-optical component. According to the present invention, the optical probe comprises

- a probe head, wherein the probe head comprises a test component;
- at least one micro-optical element, wherein the micro-optical element is a separate element with regard to the test component and in mechanical contact with the test component,

wherein the micro-optical element is configured to optically couple light between the test component and the micro-optical component, thereby being configured to determine an optical performance of the micro-optical component, and wherein the micro-optical element is configured to be operated in an index matching liquid.

As generally used, the term "optical probe" refers to an optical device, which is configured for optical testing of at least one micro-optical component. In addition, the optical probe may exhibit at least one of a mechanical functionality, an electrical functionality, or an optical functionality as described below in more detail. For a purpose of optical testing, the optical probe as used herein comprises a probe head having a test component, wherein the probe head may be aligned in a manner that light may couple between the test component and the micro-optical component. As further generally used, the term "probe head" refers to a terminal piece of the optical probe, wherein the terminal piece comprises a micro-optical element configured to optically couple light between the test component and the micro-optical component. In a particularly preferred embodiment, the probe head may be movable relative to the micro-optical component to be tested. For a purpose of being dynamically movable in an easy manner, the probe head may, preferably, exhibit a low weight.

As already indicated above, the optical probe is configured for the optical testing of at least one micro-optical component. As generally used, the term "micro-optical component" refers to a device under testing, wherein the device may, preferably, be or comprise a wafer having multiple photonic integrated circuits, or individual photonic integrated circuits. In general, then micro-optical component may comprise a plurality of optical structures that inherently assume small dimensions, preferably of 10 μm or less, more preferred of 5 μm or less, especially of 1 μm or less, configured to execute an intended function, in particular as a waveguide, or that has a total dimension 10 mm or less. In a preferred embodiment, the micro-optical component may be generated on a photonic platform, particularly selected from a SOI (Silicon on Insulator), InP (Indium Phosphide), SiN (Silicon Nitride), or LNOI (Lithium Niobate thin film). In an alternative embodiment, the micro-optical component may be a non-planar component, especially an optical element selected from a micro-lens, a grating, an optical isolator, or a mirror.

In a particularly preferred embodiment, the optical probe, especially at least one of the probe head or the micro-optical component, may have at least one liquid guarding element. may further comprise a microfluidic chip. As generally used, the term "microfluidic chip" refers to an electronic element which is configured to operate the index-matching liquid. For this purpose, the microfluidic chip may have at least one of:

- a liquid dispensing element;
- a hollow-core fiber;
- a liquid guarding element; or
- a liquid removal element.

As generally used, the term "liquid dispensing element" refers to a mechanical element or an electromechanical element, which is configured to dispense at least one portion of the index matching liquid. Preferably, the at least one liquid dispensing element may be selected from a reservoir and a dispensing nozzle; however, using a further liquid dispensing element may also be feasible. As further generally used, the term "hollow-core fiber" refers to an elongated element having a hollow core, which is configured to receive, transport, and manipulate at least one portion of the index matching liquid and may, concurrently or consecutively, be configured to guide light. As further used herein, the term "liquid guarding element" refers to a mechanical element at a surface of the probe head or the micro-optical component, which is configured to control, in particular to limit, a spread of at least one portion of the index matching liquid. Especially, a wetting behavior of a surface of the probe head or the micro-optical component may be adjusted by coating the respective surface of the probe head or the micro-optical component, in particular by exhibiting a lotus effect or sharp edges, thereby avoiding the spread of liquid. For this purpose, a metal, an oxide, an oxide removal, a fluorinated coating, an organic coating or a structured surface may be used; however using a further coating may also be feasible. Herein, the structured surface may, especially, be selected from a capillary, a sharp edge, or a hole configured to control, in particular to limit, the spread of the liquid; however, using a different structured surface may also be feasible. The liquid guarding element may, especially, be produced by 3D-printing the selected coating onto the surface of the probe head, preferably in a single process step together with generating the micro-optical element. As further generally used, the term "liquid removal element" refers to a mechanical element or an electromechanical element, which is configured to remove at least one portion of the index matching liquid. Preferably, the at least one liquid removal element may be selected from a drain outlet and a discharge reservoir; however, using a further liquid removal element may also be feasible.

As already further indicated above, the optical probe comprises a probe head having a test component. As generally used, the term "test component" refers to an optical component which is configured for transmitting or collecting light from a device under testing, in particular the micro-optical component as described elsewhere herein. The test component may, preferably, be selected from a fiber, a fiber array, a waveguide, a photonic integrated circuit, a planar transparent substrate, a curved transparent substrate, or an optical element, in particular an optical lens or an objective lens. The test component may be a testing circuit. The testing circuit may, preferably, comprise the same material, fabrication batch, wafer or technology as the micro-optical element. However, using a different type of testing circuit may also be feasible. For a purpose of optical testing of the at least one micro-optical component, the testing circuit may have active optical structures, especially be selected from at least one of a light source, such as a laser or a superluminescent light emitting diode (SLED), or a detector, such as a Ge photodiode, or it may be coupled to an optical fiber or to a fiber array, particularly to be observable by a macroscopic optical instrument. As generally used, the term "optical fiber" refers to an extended, round optical element which is configured for guiding light by using a facet, wherein the term "facet" refers to a terminal surface of a light guiding structure, especially of a waveguide, through which light is transmitted or received. As further generally used, the term "fiber array" refers to at least one optical fiber which is in connection with at least one mechanical element, preferably selected from a glass block or a V-Groove array. In a preferred embodiment, the testing circuit may have at least one of an electrical functionality, a distance sensor, a mechanical sensor, an acceleration sensor, a force sensor, or a structure having a micro-electromechanical system (MEMS). Still, further embodiments of the testing circuit may also be feasible.

As generally used, the term "photonic integrated circuit" refers to a planar device comprising at least one of a waveguide or a photonic device having at least one surface emitting device or a photosensitive device, preferably selected from a photodiode, an image sensor or a Vertical cavity surface emitting laser (VCSEL). As used herein, the term "planar" indicated that a corresponding device is obtained by using 2D-lithography on a planar substrate. Based on this definition, optical fibers are not comprised by a photonic integrated circuit, whereas devices created with the ioNext platform, SiN, SOI, or silicon rich oxide are components of a photonic integrated device. The photonic integrated circuit may comprise active and passive waveguide devices, preferably selected from a photodetector, a light source, an optical modulator, a spectrum analyzer, a power splitter, or a polarization splitter, filter or stripper, or a multiplexer. The photonic integrated circuit may also exhibit at least one advanced electrical functionality, especially a transistor, a CMOS component, an electrical line, or an electrical waveguide line. In a particularly preferred embodiment, the testing circuit and also the micro-optical component may be a photonic integrated circuit. In an alternative embodiment, the micro-optical component can be an optical integrated circuit or a micro-optical device.

As already further indicated above, the optical probe further comprises at least one micro-optical element. As generally used, the term "micro-optical element" refers to an optical structure which is configured for modifying a propagation of light, in particular by at least one of focusing, diverging, redirecting, deflecting, waveguiding, or rotating a polarization of the light. For this purpose, the micro-optical element may, preferably, comprise at least one element selected from a mirror, particularly a total internal reflection mirror or a metal mirror; an optical lens; an optical grating; an optical waveguide, particularly a non-planar waveguide; a photonic wirebond; a light taper; an optical metamaterial; or a whispering gallery waveguide. As generally used, the terms "photonic wirebond" or "PWB" refers to a 3D-printed freeform waveguide, wherein the waveguide may preferably be a single-mode waveguide, which is optionally polarization conserving, and which may, preferably, be operated in a high index contrast configuration. Herein, the term "high index contrast configuration" can be expressed by a condition of

$$n_1 - n_2 > 0.1,$$

wherein $n_1$ is the refractive index of the waveguide, and wherein $n_2$ is the refractive index of the surrounding medium. As further generally used, the term "whispering gallery waveguide" refers to an optical element having a whispering gallery guiding mechanism, wherein the optical element is a continues disc or a cylinder or a part thereof through which light travels tangential to a surface of the disc or the cylinder. As still further generally used, the term "total internal reflection" refers to a process in which light is propagating in a medium having a higher refractive index compared to the higher refractive index of a surrounding medium, wherein the light interacts with the interface between the two media in a manner that the light is contained in the material having the higher refractive index. As a result, the light may be guided, in particular in a waveguide, especially in a single-mode waveguide, or reflected at a surface. An optical element, which is designed in a manner that internal reflection is maintained, is configured for enabling a process in which light propagating from a material having a higher refractive index is reflected at an optical interface of the optical element, if the reflection angle is below a critical angle. In case of a waveguide, the optical element is designed in a manner that a curvature radius is selected such that at least 90% of the incident light is not emitted in a 90° bend.

The micro-optical element may, preferably, be a three-dimensional element, wherein the term "three-dimensional element" refers to an object having an extension of at least 1 μm has in all spatial directions and is obtained in a direct 3D-printing process. Preferably, the micro-optical element may have at least one free-form surface, wherein the at least one free-form surface may be a computer-programmable surface. More preferred, the micro-optical element may have a 3D freeform-structure. Preferably, the micro-optical element may have overall extensions of 1000 μm or less, more preferred of 500 μm or less, in particular of 250 μm or less. Preferably, the micro-optical element may have at least one optical surface of a surface roughness of 250 nm or less, more preferred of 100 nm or less, in particular of 20 nm of less, root-mean-square as measured by at least one of an atomic force microscope (AFM) or a white-light interferometer. Preferably, the micro-optical element may be transparent from 250 nm to 4500 nm, more preferred of at least 530 nm to 2700 nm; however, a different transparent wavelength range may also be feasible.

Preferably, the micro-optical element may be produced by using a polymeric material, in particular an acrylic material, especially by light curing the polymeric material. Herein, an additive manufacturing process may, preferably, be used; however, using a different type of at least one of the polymeric material or the manufacturing process may also be feasible.

Preferably, the micro-optical element may be produced in a manner that an alignment accuracy of at least 1000 nm, more preferred of at least 500 nm, in particular of at least 100 nm, with respect to a coupling location at the test component may be obtained. As a result, the mode-field pitch of the micro-optical element may, preferably, vary 1000 nm or less, more preferred 500 nm or less, in particular 100 nm or less. Preferably, the micro-optical element may be produced, especially by using a direct-write method, in a manner that the alignment accuracy of at least one optical effective portion of the micro-optical element and/or portion of the micro-optical element interacting with light of at least 1 μm, more preferred of at least 500 nm, in particular of at least 100 nm, may be obtained. Preferably, the micro-optical element may be produced in a manner that a shape accuracy of the micro-optical element of at least 1 μm, more preferred of at least 500 nm, in particular of at least 100 nm, may be obtained. As used herein, the term "shape accuracy" refers to a maximum deviation that is to be expected for a single device when performing a measurement by using an appropriate metrology and comparing a measured shape to a designed shape.

The optical structure of the micro-optical element which is configured for modifying the propagation of light can, preferably, be configured to generate a mode-field diameter of the wavelength of the light up to 50 μm. Preferably, the generated mode-field diameter may be close to the mode-field at the coupling location of the micro-optical component. Herein, generating the mode-field diameters refers to an optical arrangement which configured to create a mode-field having the corresponding mode-field diameter. By way of example, at a wavelength of 1.55 μm of incident light, the mode-field diameter may, preferably, be 1.55 μm to 50 μm. As generally used, the term mode-field diameter refers to a diameter at a $1/e^2$ intensity of a waist of the beam; however, using a different definition may also be feasible. In general, the mode-field diameter may be measured at the waist of the beam, which may, typically, be aligned with a coupling location to achieve a best coupling between the probe head and (the at least one micro-optical component. A one-sigma-variation of the mode-field between different structures may, preferably, be 20 % or less, more preferred 10 % or less, while a resulting coupling variation may, preferably, be 5% or less when coupling into identical components.

In a preferred embodiment, the test component may reduce a mode-field diameter at a coupling location of the test component to generate a divergent beam being emitted by the coupling location of the test component. This embodiment allows designing a particularly compact micro-optical element having a relatively large working distance. Smaller mode fields of the test component compared the mode-fields of fiber cores may result in a micro-optical element having reduced dimensions and, therefore, enabling a probing in narrower trenches. In addition, a time for producing of the micro-optical element can be decreased.

As indicated above, the micro-optical element is configured to be operated in an index matching liquid. As generally used, the term "index matching liquid" refers to a liquid medium having a refractive index which differs from the refractive index of air or a vacuum. In particular, the refractive index of the index matching liquid may be at least 1.01. In a preferred embodiment, the index matching liquid may be selected from at least one of:

- a liquid assuming a gaseous state at room temperature, especially oxygen, nitrogen, hydrogen, or carbon dioxide, or a cryogenic liquid, such as helium, wherein the liquid may comprise at least one halogenated molecule, in particular at least one fluorinated molecule, wherein the molecule may, preferably, be a hydrocarbons;
- water;
- a solvent, in particular selected from acetone, 1-Methoxy-2-propylacetat (PGMEA), 1-Methoxy-2-propanol (PGME), or 2-Propanol (IPA);
- silicone;
- a monomer;
- an uncured adhesive, in particular a UV curable adhesive or an adhesive designed for optical packaging, especially selected from an epoxy adhesive or an acrylic adhesive; or
- a liquid designed to exhibit a wetting behavior of the micro-optical component, wherein the particular liquid may, preferably, be configured for wetting at least one optical functional part of the micro-optical component but avoids further spread of the liquid.

However, using a further index matching liquid may also be feasible.

As generally used, the phrase "configured to be operated in an index matching liquid" refers to a design process, especially to a calculation step or a simulation step, wherein the refractive index of the index matching liquid has to be taken into account for a proper functioning of the micro-optical element, in particular to avoid that a transmission through the index matching liquid would degrade by at least 1 dB. Especially, lens surfaces having a stronger curvature than a corresponding lens design for air are used in the design process for achieving the same numerical aperture (NA).

In a preferred embodiment, at least one optical interface may be tilted with respect to a light propagation direction, particularly to suppress unwanted back-reflection. Preferably, angled fiber arrays having an angle of 5° to 20° may be used. Further, a suitable design my be used for compensating effects obtained by the tilting.

In a further preferred embodiment, at least one surface may be designed for generating an elliptical mode-field at a beam waist, in particular at a focus, in order to match mode-fields at at least one coupling location of the micro-optical component. Preferably, an elliptical mode-field without astigmatism may be used, which has at least two optical interfaces in case of a round mode-field at the coupling location of the test component, especially if the working distance may be considered a free parameter.

In a preferred embodiment, the test component may be configured to provide mode-fields having a selected pitch and a selected mode-field diameter. As generally used, the term "pitch" refers to a distance between two objects, in particular optical elements, two coupling locations, two mode-fields, or two parallel waveguides. The pitch may be irregular or constant. A preferred pitch may be selected from a value of 80 $\mu$m and below, 127 $\mu$m or 250 $\mu$m; however, using a different value may also be feasible. A micro-optical component having a particular pitch is used herein as a micro-optical component comprising at least one pair of coupling locations, mode-fields or parallel waveguides having the particular distance. A pitch variation refers to a deviation from a specification. Further, the expression "modification of a pitch" either refers to altering the valued of a pitch, e.g. from a pitch of 127 $\mu$m at the fiber array connected to the test component to a different pitch e.g. 20 $\mu$m at the micro-optical component, or to equalizing a pitch, by e.g. compensating small variations of a fiber array pitch. Herein, the term "equalizing" refers to a process of reducing pitch inaccuracies of a fiber array, typically up to 1 $\mu$m to a pitch variation of at least 500 nm, preferably of at least 100 nm, in particular of at least 50 nm. The equalization can, preferably, be combined with a calibration measurement which takes into account a variation of the transmission. For the term "fiber array", reference can be made to the definition above. In a preferred embodiment, the test component may match different pitches, particularly to overcome known shortcomings that no pitches below 80 $\mu$m are currently achievable by using a fiber array as the optical fiber, which has a typical minimum diameter of 80 $\mu$m. Processes which may reduce the fiber diameter to 80 $\mu$m or less may often result in a larger pitch variation and are, therefore, not desirable.

In a particular embodiment, the probe head may be configured to function as an optical phase array. As generally used, the term "optical phase array" refers to an optical element having at least one mode-field. In general, a plurality of separated mode-fields can be used. At least one of a phase, an intensity or a polarization of the at least one mode-field can be modified to manipulate a field distribution as emitted by the mode-field. In a preferred embodiment, an array of waveguides at a facet of the test component, preferably combined with a taper enlarging the mode-field, can be used. The phase and intensity of the light emitted by the waveguides at the facet may be modified by using or a device configured to control phase and/or intensity, in particular a Mach-Zehnder interferometer, within the photonic integrated circuit.

As further already indicated above, the micro-optical element is a separate element with regard to the test component. As generally used, the expression that two individual elements are "separated from" from each other refers to a spatial arrangement in which two individual elements comprise different materials and/or are generated by applying at least one processing step to at least one of the elements independent from the other element. By way of example, a prism may be 3D-printed on an already existing fiber, thereby not altering the fiber, whereby the prism is considered as being separated from the fiber. In contrast hereto, the prism it is not considered as being separated from the fiber if the prism may be introduced into the already existing fiber, e.g. by milling, etching or polishing the prism into the fiber. The feature that the micro-optical element is a separate element with regard to the test component exhibits the advantage that a design freedom and a precision of the micro-optical element can be higher compared to a micro-optical element which is not a separate element with regard to the test component.

As further already indicated above, the micro-optical element is in mechanical contact with the test component. As further generally used, the term "mechanical contact" refers to a spatial arrangement of two individual elements in that the two individual elements maintain their spatial position with respect to each other. Herein, the mechanical contact may be a direct mechanical contact or an indirect mechanical contact. Whereas the term "direct mechanical contact" indicates a spatial arrangement in which both individual elements touch each other at adjoining points or surfaces, the term "indirect mechanical contact" indicates a further spatial arrangement in which both individual elements maintain their spatial position by using at least one further element. By way of example, the at least one further element may be a common carrier to which the two individual elements are mounted, or a separating element between the two individual elements. In preferred embodiments, the micro-optical element may be in mechanical contact with the test component by having attached the micro-optical element to a facet comprised by the test component, or a 3D-printed spacer may be placed between the micro-optical element and the test component, or the micro-optical element may be attached to a mechanical support, in particular a fixture, which may, directly or indirectly, be in mechanical contact with the test component. For this purpose, the micro-optical element may be fixed to the mechanical support which is in mechanical contact with the test component. As generally used, the term "fixing" refers to particular process applied to one or two elements, wherein the particular process results in a permanent mechanical contact between the two elements. Preferably, a joining element, such as a mechanical clamp, can be used for fixing the two elements. Herein, the process may, especially, comprise applying at least one adhesive, preferably a UV curable adhesive, and curing the adhesive or a mechanical clamp. In preferred embodiment, the adhesion promoter may be used to increase a robustness of the mechanical contact.

According to the present invention, the micro-optical element is configured to optically couple light between the test component and the micro-optical component. As generally used, the term "light" refers to electromagnetic radiation in the near ultraviolet range, the visual range, the near infrared range, and the medium infrared range, referring to a wavelength range of 100 nm to 10 $\mu$m, preferably of 200 nm to 4 $\mu$m, more preferred 400 nm to 2.7 $\mu$m, especially at least 1250 nm to 1650 nm. As further generally, the term "optically coupling" refers to a process of transmitting light between two optical elements, preferably two waveguide-based elements. By way of example, the coupling process may comprise transmitting light from a laser into an optical waveguide, or between two individual optical waveguides. Preferably, the coupling process may be performed in a manner that the optical coupling between the two optical elements may be maximized, in particular by translating or tilting at least one of the optical elements with respect to each other. In a further preferred embodiment, a tolerance may be maximized, e.g. by using a large mode-field, wherein the term "tolerance" refers to an alteration of an optical coupling with respect to at least one of a translational movement or a rotational movement.

In particular, the term "coupling efficiency" is generally used for indicating a resulting effect of the optical coupling as achieved by the coupling process between the two optical elements. Preferably, a coupling efficiency between two optical waveguides may be 0.5 dB to 3 dB. However, only a significantly lower coupling efficiency can be acceptable in certain embodiments as known to the person skilled in the art. Further, the term "coupling tolerance" corresponds to a reduction of 1 dB with respect to a translational movement. The coupling tolerance may, preferably, be at least 0.5 $\mu$m, preferably at least 1 $\mu$m, more preferred at least 2 $\mu$m in a

transversal direction with regard to a light beam and at least 2 $\mu$m, preferably at least 5 $\mu$m, more preferred at least 10 $\mu$m in a direction of the light beam. Similarly, a rotational tolerance may, preferably, be at least 0.1°, preferably at least 0.5°, more preferred at least 1°.

The micro-optical element, which is configured to optically couple light between the test component and the micro-optical component, is, in accordance with the present invention, configured to determine an optical performance of the micro-optical component. As used herein, the term "optical performance" refers to at least one parameter being indicative for at least one property of at least one optical element. Herein, the optical performance may, preferably, refer to the optical micro-optical component, however the optical performance of at least one further optical element, particularly selected from the probe head, the micro-optical element, the test component, especially the photonic integrated circuit, or the fiber array, can also be referred to. The optical performance may, especially, refer to at least one of the coupling efficiency of a known mode-field to the micro-optical component, a polarization property, a back-reflection property, a pitch-accuracy, a waveguide propagation loss, a spatial and/or angular distribution of light emitted into free space, a modulator performance such as modulation speed, an extinction ratio, a laser performance such as a relative intensity noise, an light current-voltage (LIV) characteristics, a linewidth, an amplification of a semiconductor optical amplifier (SOA), a responsivity of a photodiode, a bandwidth of an optical element in a temporal domain and/or a frequency domain, a back-reflection, a bit-error rate of an optical data transmission, a pitch, a transmission; however, using at least one further parameter may also be feasible.

For this purpose, the test component may have an optical functionality, wherein the optical functionality may be independent from the optical functionality operating the micro-optical element. In addition, the test component may have at least one of a mechanical functionality or an electrical functionality. As generally used, the term "optical functionality" indicates that the test component comprises at least one photonic integrated circuit, which is configured for characterizing at least one optical performance of a micro-optical component as described above. Similarly, the term "mechanical functionality" indicates that the test component comprises at least one functionality, which is configured for characterizing at least one mechanical performance of a micro-optical component, particularly selected from at least one parameters of a MEMS actuator, in particular a response time, or a mechanical behavior of a surface acoustic wave sensor. Further, the term "electrical functionality" indicates that the test component comprises at least one functionality which is configured for characterizing at least one electrical performance of a micro-optical component, particularly selected from at least one of a characteristics parameters of semiconductor junctions such as capacitance, a performance of a modulator, an operating parameter of a laser, or a photocurrent configured for measuring a resistance.

In general, characterizing the optical performance refers to a measurement of performance. The purpose of characterizing the optical performance is to generate a temporary optical coupling to determine the optical performance. Herein, a measurement of the optical performance may, in particular, comprise measuring at least one of a pitch, a mode-field, an angular distribution of light emitted from the probe, a coupling efficiency to a known component and a transmission from an optical fiber connected to a probe into free space. The measurement of the optical performance may, in addition, comprise measuring at least one mechanical or electrical property resulting in at least one optical signal, e.g. a characterization of a micro-mechanical switch for switching light between waveguides. In contrast hereto, optical packaging is not used herein for characterizing the optical performance of the micro-optical component, since optical packaging provides a permanent optical connection in order to effect an operation of the micro-optical component rather than measuring its optical performance.

In a preferred embodiment, the optical performance of the probe head may be calibrated. As generally used, the term "calibrated" refers to a measurement of a performance which is accounted for in a subsequent step. Preferably, the calibration may comprise a numerical compensation of a measured coupling loss, a rework, scrapping an element or altering measurement parameters in a subsequent step according to the characterizing the optical performance.

In a further aspect, the present invention relates to a use of the optical probe as disclosed elsewhere herein, wherein the optical probe is configured for optical testing of a micro-optical component, wherein the micro-optical component comprises at least one of:

- a liquid guarding element;
- a structure configured to be operated in the index-matching liquid, wherein the structure is, particularly, selected from an optical structure, a mechanical structure or an optomechanical structure;
- a metamaterial taper configured to be operated in the index-matching liquid, wherein the taper is, particularly, selected from a metamaterial taper, a suspended taper or an adiabatic taper;

and/or wherein the micro-optical component is configured for being operated in a liquid cryogenic environment.

As generally used, the term "operate in a liquid cryogenic environment" refers to a process in which the optical probe and the micro-optical component are at least partially immersed in a cryogenic liquid during the optical testing of at least one micro-optical component. For this purpose, at least one material may be selected for the optical probe and the micro-optical component, which is known neither to be damaged nor to be delaminated at cryogenic temperatures, particularly due to a good adhesion, a soft consistence, a small diameter, a matched coefficient of thermal expansion (CTE), or material interlocking. Preferably, a change of at least one optical property, particularly selected from a refractive index, an optical path length, or an optical absorption; or at least one mechanical property, particularly selected from a length change, a bend, a deformation, or a torsion; are avoided by an appropriate design or by a pre-compensation in order to function at the desired cryogenic temperature.

In a further aspect, the present invention relates to a method for producing an optical probe, in particular the optical probe as described elsewhere herein. The method comprises at least the following steps i) and ii):

> (i) providing a probe head, wherein the probe head comprises a test component; and
> (ii) generating at least one micro-optical element by using a direct-write process, wherein the micro-optical element is being generated as a separate element with regard to the test component and in mechanical contact with the test component,

wherein the micro-optical element is configured to optically couple light between the test component and a micro-optical component, thereby being configured to determine an optical performance of the micro-optical component, and wherein the micro-optical element is configured to be operated in an index matching liquid.

Herein, the indicated steps may, preferably, be performed in the given order, commencing with step (i) and finishing with step (ii). However, any or all of the indicated steps may also be repeated several times and/or preformed concurrently in part.

According to step (i), the probe head is provided, wherein the probe head comprises a test component. For the terms "probe head" and "test component", reference can be made to the definitions above.

According to step (ii), the at least one micro-optical element is generated by using a direct-write process, wherein the micro-optical element is being generated as a separate element with regard to the test component and in mechanical contact with the test component, in a manner that the micro-optical element is configured to optically couple light between the test component and the micro-optical component, thereby being configured to determine the optical performance of the micro-optical component. For the terms "micro-optical element", "separate element" and "mechanical contact", reference can be made to the definitions above. As generally used, the term "direct-write process" refers to a process in which a programmable beam, particularly selected from a photon beam or an electron beam, alters a solvability of a material, especially of a photoresist, in a manner that, after a development step, a desired structure is obtained. In a particularly preferred embodiment, a multi-photon absorption process of a material is used, preferably of acrylic material that is cross-linked upon irradiation, preferably by using a fs-laser and a negative-tone resist. By way of example, by laser irradiation the acrylic material is polymerized in a manner that it is less curable after the development step. Preferably, a light distribution may be spatially modified while irradiating the photoresist. More preferred, the spatial light distribution may be spatially modified by scanning a laser beam by using a galvo scanner, or by dynamically altering a photomask, especially by a spatial light modulator. Herein, the irradiation may alter the solubility of the photoresist. In particular, the photoresist may be liquid prior to irradiation, and may cured upon irradiation. Particularly preferred, two-photon polymerization or multi-photon polymerization may be used herein for curing of the photoresist; however using a different type of irradiation may also be feasible. After irradiation the structure may be developed by using at least one solvent being configured to remove not-cured resist portions, particularly selected from 1-Methoxy-2-propylacetat (PGMEA), 1-Methoxy-2-propanol (PGME), or 2-Propanol (IPA).

In a preferred embodiment, the micro-optical elements may be produced on the test component which may be connected to a single-mode fiber array, a single-mode fiber array, or a transparent substrate. In a further preferred embodiment, the test component may be produced in the same wafer run as the micro-optical component or in the same production step of an interposer configured for coupling a further micro-optical component to an optical fiber. In this manner, arbitrarily complex pitch sequences matching different pitches of the test component can be achieved. Additionally, time and effort required for producing an optical probe can be reduced in this manner, particularly since the test component is available at the same point of time as the micro-optical component.

The fabrication of the micro-optical elements on test components instead of fiber arrays exhibits various advantages in terms of reliability. Due to finite production accuracy of V-groove arrays and due to core-cladding non-concentricity and fixation inaccuracies, fiber arrays have a typical pitch accuracy of 0.5 $\mu$m, the sigma is typically at about 0.2 $\mu$m. For small mode-field diameters at micro-optical elements of typically 3 $\mu$m and less, larger coupling efficiency variations can occur if optical lenses may be aligned to the fiber core of fiber arrays. In contrast hereto, a photonic integrated circuit comprises a relatively perfect pitch having pitch accuracies of 50 nm or less, particularly since it is defined with lithographic precision. If the micro-optical element may be aligned to a coupling location of the test component, producing optical probes having near-perfect pitches becomes possible. If the test component comprises a photonic integrated circuit that is connected to a fiber array, the fiber array may still have a pitch inaccuracy and the coupling variation may occur at the coupling location between the fiber-array and the test component. The mode-field size may, however, be matched towards the fiber array connection facet to about 10 $\mu$m, thus, making the pitch inaccuracy of the fiber array less relevant, especially since pitch inaccuracies are smaller relative to the mode-field diameter of the optical fiber. In addition, the coupling efficiency variation between the fiber array and the test component may be calibrated. Still further, the test component may have integrated sensor elements or emitter elements, thereby avoiding the coupling to the fiber array. Still further, the test component may have at least one distance sensor, especially selected from an optical distance sensor or an electrical distance sensor, which may be configured for simplifying navigation when small drops of index matching liquid are dispensed at the probe head.

In a preferred embodiment, the method may, further, comprise the following step:

(iii) applying an adhesion promoter to the test component prior to step (ii);
(iv) mounting the at least one micro-optical element on a support prior to step (ii).

As generally used, the term "adhesion promoter" refers to a substance, which may be comprised by a photoresist, or may be applied separately, or to a process step, which is configured to treat a surface for increasing an adhesion of the surface, especially compared to not using an adhesion promoter. Preferably, the adhesion promoter may be selected from a functionalization of the surface, particularly a plasma treatment, or a silanization; a surface layer removal; an etching step; or a coating step, e.g. by using a material inherently having good adhesion, such as chromium. In a preferred embodiment, the adhesion promoter may be integrated in a photoresist by comprising an added substance known to enhance adhesion. However, using a different type of adhesion promoter may also be feasible.

In a further preferred embodiment, the method may, further, comprise the following step:

(v) detecting at least one marker within the test component prior to step (ii);
(vi) generating at least one marker configured for alignment during step (ii);

As generally used, the term "marker" refers to a structure which is configured for alignment in at least one degree of freedom. Herein, the marker may be a structure, explicitly or implicitly, dedicated for this purpose, or it may be a functional element, especially selected from a waveguide or a ridge, of the test component. A particular marker may already be comprised by the test component during step (i), or it may be generated in the direct-write process during step (ii). In particular, the marker may facilitate the alignment between the probe head and the micro-optical component to optically couple light. In this manner an automated alignment between the probe head and the micro-optical component with respect to each other can be achieved. The marker may, preferably, be designed or positioned in a manner that a view onto the marker may not be disturbed by the index matching liquid.

In a further preferred embodiment, the method alternatively or in addition, further comprise at least one of the following steps:

(vii) detecting the light being emitted from the test component prior to step (ii);

(viii) optically coupling the light into the test component for detecting a coupling location prior to step (ii);

(ix) applying index matching liquid at a coupling location in a manner that light is at least partially transmitted through the index matching liquid;

(x) aligning the micro-optical element with respect to a fiber core comprised by the test component to a variation of at least 1 $\mu$m, preferably of at least 500 nm, preferably of at least 100 nm;

(xi) calibrating the optical performance of the optical probe after step (ii); wherein the optical performance of the optical probe may, preferably, be calibrated in a material having the same refractive index as the index matching liquid.

For further details concerning the method for producing an optical probe, reference can be made to the disclosure of the optical probe as provided elsewhere herein.

In a further aspect, the present invention relates to a method for optical testing of at least one micro-optical component, in particular by using the optical probe as described elsewhere herein. The method comprises the following steps a) to c):

a) providing an optical probe, wherein the optical probe comprises a probe head and at least one micro-optical element, wherein the probe head comprises a test component, wherein the micro-optical element is a separate element with regard to the test component and in mechanical contact with the test component; and

b) positioning the probe head in a manner that the micro-optical element optically couples light between the test component and the micro-optical component, wherein the light at least partially propagates through an index matching liquid, wherein the index matching liquid is at least partially in contact with the at least one micro-optical component; and

c) determining an optical performance of the micro-optical component by measuring an optical signal being indicative for the optical performance of the micro-optical component.

Herein, the indicated steps may, preferably, be performed in the given order, commencing with step a) and finishing with step c). However, any or all of the indicated steps may also be repeated several times and/or preformed concurrently in part.

According to step a), an optical probe, preferably the optical probe as described elsewhere herein, is provided.

According to step b), the probe head is positioned in a manner that the micro-optical element optically couples light between the test component and the micro-optical component.

According to step c), the optical performance of the micro-optical component is determined by measuring an optical signal being indicative for the optical performance of the micro-optical component.

In a particularly preferred embodiment, the method for optical testing of the at least one micro-optical component may, further, comprises at least one of the following steps:

d) calibrating the optical performance of the probe head prior to performing step (b), preferably in the index matching liquid;

e) inserting at least one part of the micro-optical element into a trench comprised by the micro-optical component in a manner that the light is optically coupled between the test component and the micro-optical component;

f) dispensing the index matching liquid prior to or during step b);

g) removing the index matching liquid during or after step b) or step c);

h) determining the optical performance of the micro-optical component during step c) prior to, under, or after an application of the index matching liquid;

i) altering a temperature of the micro-optical component or a surface thereof at least during step c);

j) treating the optical probe in a critical point dryer at least during step c); or

k) operating the optical probe by using a broadband light source having a linewidth of at least 5 nm at least during step c).

For further details concerning the method for optical testing of at least one micro-optical component, in particular by using an optical probe, reference can be made to the disclosure of the optical probe as provided elsewhere herein.

As used herein, the terms "have", "comprise" or "include" or any arbitrary grammatical variations thereof are used in a non-exclusive way. Thus, these terms may refer to both a situation in which, besides the feature introduced by these terms, no further features are present in the entity described in this context and to a situation in which one or more further features are present. As an example, the expressions "A has B", "A comprises B" and "A includes B" may both refer to a situation in which, besides B, no other element is present in A (i.e. a situation in which A solely and exclusively consists of B) and to a situation in which, besides B, one or more further elements are present in entity A, such as element C, elements C and D or even further elements.

As further used herein, the terms "preferably", "more preferably", "particularly", "more particularly", or similar terms are used in conjunction with optional features, without restricting alternative possibilities. Thus, features introduced by these terms are optional features and are not intended to restrict the scope of the claims in any way. The invention may, as the skilled person will recognize, be performed by using alternative features. Similarly, features introduced by "in an embodiment of the invention" or similar expressions are intended to be optional features, without any restriction regarding alternative embodiments of the invention, without any restrictions regarding the scope of the invention and without any restriction regarding the possibility of combining the features introduced in this way with other features of the invention.

Advantages of the invention

With respect to the prior art, the optical probe and the related methods exhibits the following advantages. The optical probe can be configured for optical testing of components on die, batch, and wafer level. The optical probe may have a compact probe head that can be inserted and probe in a trench of a wafer, wherein the trench may, preferably, 250 $\mu$m or less, more preferred 100 $\mu$m or less, especially 80 $\mu$m or less. Further, the optical probe can be configured for a small pitch, preferably of 127 $\mu$m or less, more preferred of 80 $\mu$m or less, especially of 50 $\mu$m or less. Herein, having a high pitch accuracy of sigma = 300 nm or better and a low mode-field size variation of sigma = 10% or less is possible.

Further, the optical probe can be configured for a high port count, preferably of at least 24, more preferred of at least 64, especially of at least 128. Preferably, a small mode-field, preferably of 10 $\mu$m or less, more preferred of 5 $\mu$m or less, especially twice an operation wavelength or less, may be available at a coupling location of the test component. Further, a calibration of probe variations may be possible. The optical probe can be configured for robust probing even at high working distances. Preferably, the optical probe may implement one or more functionalities, such as distance measurement, local probing of polarization, multiplexing, modulation, spectral analysis, intensity and phase measurements, heterodyne detection and transmittance of signals. In addition, achieving a high testing throughput by parallelization, measurement of more than 1 channel or by switching involving no mechanical movements, is possible.

Further, the optical probe can be configured for working in the near ultraviolet range, the visual range, the near infrared range, and the medium infrared range, referring to a wavelength range of 100 nm to 10 $\mu$m, preferably of 200 nm to 4 $\mu$m, more preferred 400 nm to 2.7 $\mu$m, especially at least 1250 nm to 1650 nm. A high reproducibility of the optical coupling between the probe head and the at least one micro-optical component with variations of 0.5 dB or less, more preferred of 0.25 dB or less can be obtained.

Further, the optical probe according to the present invention is configured for reliably characterizing the performance of a micro-optical component, wherein at least one optically functional part, such as a coupling location, of the micro-optical component can easily be immersed in an index matching liquid without adverse effects. In this manner, a performance of the micro-optical component can be characterized, which is optically close or identical to an intended operation of the micro-optical component. The present invention, thus, allows a high degree of design freedom, especially for performing test measurements, preferably under a similar refractive index as the final operation of the devices. The micro-optical components to be tested do not function well or are not comparable to their final application if operated in air. If a test measurement may be performed in air, it cannot be considered as representative for a final operation of the device under testing. The optical probe and the related methods are, advantageously, suitable for a cryogenic environment and immersion in cryogenic liquids, such as liquid nitrogen or liquid helium.

Further, the optical probe according to the present invention may comprise an optical element that is operational or configured to be operated in both liquid environment with liquids of a refractive index of at least 1.2 and in air. In a preferred embodiment, this optical element can be selected from a flat mirror, a curved mirror, or a freeform mirror coated with a reflective layer of a metal, a dielectric, a micro-structured surface, a moths-eye surface optionally generated by 3D-printing, a surface showing the lotus effect, an air holding structure, a grating, or a cavity. The surface of the optical element may also be configured such that all rays may be transversing the surface perpendicular to the surface, such that the refractive index of the environment of the probe does not matter. This preferred embodiment allows using the same probe for both testing in air and liquid, or in liquids having different refractive index, thus allowing comparison of measurements and reducing product variation.

In particular, reflection may change a performance of an optical component, such as a laser, or may change the performance of optical mode-field converter structures. Therefore, the test measurement may, preferably, be performed in a liquid medium having a refractive index which is dissimilar from air, i.e. being at least n = 1.01. Advantageously, the index matching liquid does not prevent alignment of the optical probe with the micro-optical component. It is suitable for edge-couplers and grating couplers and does not change the polarization. Moreover, the present invention does, typically, not include further steps which require vacuum; therefore, using it is easy, straightforward and cost-effective.

Moreover, the index matching liquid can be coarsely dispensed, optionally being in contact with the complete micro-optical element, at least one part or the complete probe head, and optionally the complete wafer. This particular embodiment allows using technically robust and cost effective dispensing systems, as the index matching liquid must not be restricted to certain regions, e.g. only the space between a lens and the micro-optical component, especially the corresponding coupling location. Restricting the cladding to such a small portion of the assembly would require a complex and unreliable dispensing technology, which is avoided by using the present invention.

The index matching liquid inherently comprises substances configured to extend beyond a pure suppression of back reflection at facets. In particular, the index matching liquid avoids parasitic reflection at a top oxide to air and a bottom oxide to a silicon interface and, thus, allows spotting size converters for a proper functioning. Advantageously, the index matching liquid can be or comprise a curable adhesive, preferably a curable epoxy. Herein, the epoxy can, additionally, exhibit a mechanical functionality, especially for permanently fixing the optical components to be connected. In particular, optical single-mode fibers can be fixed in V-Grooves of SOI chips. The operation of the optical probe and the micro-optical component can take place in an index matching liquid having a refractive index of 1.01 to 2.0, preferred of 1.35 to 1.5. The index matching liquid can be influenced by light, heat, or moisture. As a further advantage, calibration of the optical probe in the desired environment is possible, also in the desired environment concerning refractive index and other optically effective influences.

Short description of the Figures

Further optional features and embodiments of the present invention are disclosed in more detail in the subsequent description of preferred embodiments, preferably in conjunction with the dependent claims. Therein, the respective optional features may be implemented in an isolated fashion as well as in any arbitrary feasible combination, as the skilled person will realize. It is emphasized here that the scope of the invention is not restricted by the preferred embodiments. In the Figures:

Figures 1 and 2    each illustrates an exemplary embodiment of an optical probe configured for optical testing of a micro-optical component;

Figures 3 and 4    each illustrates exemplary embodiments of a probe head and a micro-optical element;

Figure 5    illustrates a further exemplary embodiment of the optical probe;

Figure 6    illustrates an exemplary embodiment of the test component and the micro-optical component;

Figure 7    illustrates a facet view directed at a facet of the test component;

Figures 8 and 9    each illustrates a further exemplary embodiment of the optical probe and the micro-optical component;

Figure 10    illustrates a further exemplary embodiment of the test element and the micro-optical element;

Figure 11    illustrates a further exemplary embodiment of the optical probe; and

Figure 12    illustrates an exemplary embodiment of a method for producing the probe head.

Detailed description of the embodiments

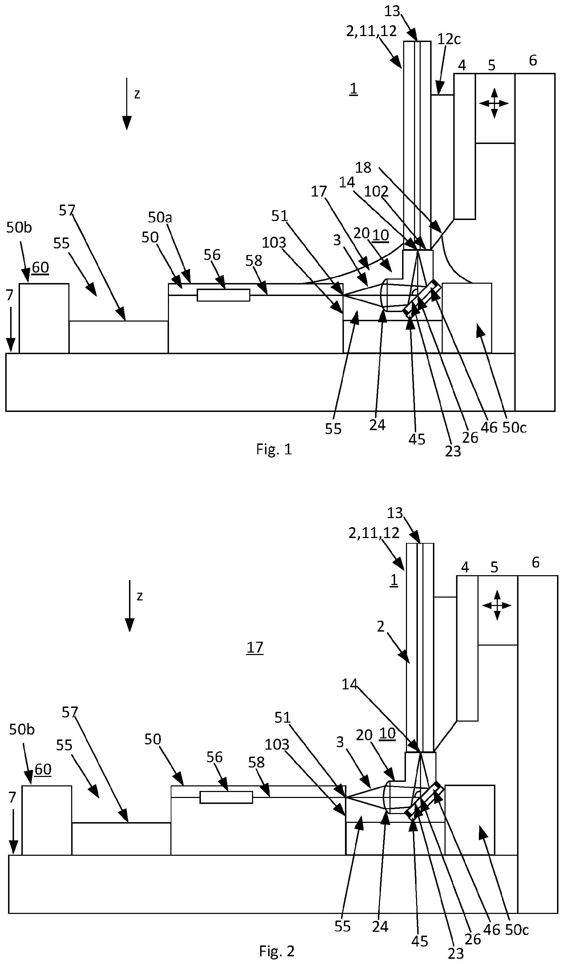

Figure 1 illustrates an exemplary embodiment of an optical probe 1 configured for optical testing of a micro-optical component 50. The optical probe 1 comprises a micro-optical element 20 configured for optically coupling light 3 between the micro-optical component 50 and a test component 2 at coupling locations 51, 14, wherein the light 3 is transmitted through facets 103, 102, respectively. In the exemplary embodiment of Figure 1, the micro-optical element 20 is configured to redirect the light 3 in an angle 26 of 90°. The light 3 may travel from the test component 2 to the micro-optical component 50, from the micro-optical component 50 to test component 2, or simultaneously in both directions. The micro-optical component 50 is fixed on a mechanical support, such as a chuck 7, either permanently or by using vacuum tools or at last one adhesive. In some embodiments, an optical functionality of a functional element 56, being part of the micro-optical component 50, e.g. a waveguide, a laser, or a photodiode, which may be coupled to a waveguide 58, may be characterized, e.g. by using optical transmission properties of the waveguide 58, or a spot size converter at the coupling location of the micro-optical component 50. Several probe heads 10 may be simultaneously or sequentially aligned to coupling locations of the micro-optical component 50, e.g. to test multi-port devices, such as semiconductor optical amplifiers, SOAs. The probes heads 10 may have several channels for coupling, especially by having a plurality of coupling locations 51.

As further depicted in Figure 1, the probe head 10 is at least partially embedded in an index-matching liquid 17. The refractive surface 24 is designed to function in the index-matching liquid 17; by way of example the refractive index of the index-matching liquid 17 was considered during the design of the shape of the refractive surface 24. A reflecting surface 23 is also designed to function in the index-matching liquid 17. Herein, the reflecting surface 23 may be designed such that total internal reflection does not fail due to the reduced refractive index of the material of the micro-optical element 20 with regard to the index-matching liquid 17 compared to the micro-optical element 20 with regard to air or vacuum.

For this purpose, a containment structure 45 is used. The containment structure 45 may have gaps to ensure that a liquid photoresist can leave a cavity 46 during a development step, or the cavity 46 may be filled with a medium preferably having a low refractive index, in particular being lower than the refractive indices of the index-matching liquid 17 and the micro-optical element 20. This medium may be such that it displaces the liquid photoresist and that it is dispensed prior to a chemical development of the liquid photoresist during the a manufacturing process of the micro-optical element 20. Preferably, the index-matching liquid 17 may be chosen such that it does not penetrate the cavity 46. By way of example, a high viscosity liquid or a surface tension liquid that does not allow 17 to penetrate 46. Further, the containment structure 45 or another part of the micro-optical element 20 may be designed such that the index-matching liquid 17 does not penetrate the cavity 46 may be used, in particular by generating a nanostructured surface showing a lotus effect, by implementing 3D-printed valves or capillaries, or by sealing the cavity 46. Alternatively or in addition, an air holding structure, such as spicks, or tips may be used. Preferably, the method disclosed in Qu et al., see above, can be used to generate the cavity 46. In a further embodiment, the reflecting surface 23 may focus light 3 to the coupling location 51, whereas the refractive surface 24 may be designed to function identically or to function similarly in absence and presence of the index matching liquid 17, especially by configuring the refractive surface 24 in a manner that rays transfer the refractive surface 24 perpendicular to the surface of the refractive surface 24 24, or by providing the refractive surface 24 with a flat surface. As used herein, the term "to function similarly" is referring to an arrangement which exhibits a difference in coupling efficiency of not more than 6 dB of the light 3 into the micro-optical component 50 in presence compared to absence of the index matching liquid 17, preferably of not more than 3 dB, more preferred of not more than 1 dB.

Figure 2 illustrates a further exemplary embodiment of the optical probe 1, in which the index-matching liquid 17 covers a larger region of the optical probe 1 or the probe head 10 and the micro-optical component 50. The complete arrangement may be encapsulated, e.g. in a cryostat, vacuum chamber or critical point dryer. The critical point dryer may allow a removal of the index-matching liquid 17, or a replacement of the index-matching liquid 17 with at least one further liquid. A cryostat may allow testing at cryogenic temperatures, wherein the index-matching liquid 17 may be selected from a substance typically used in a cryostat, such as liquid helium or nitrogen. The index matching liquid 17 may also only partially cover the optical probe 1, wherein the index matching liquid 17 may, in particular, not be in contact with a translation stage 5 as comprised by the optical probe 1.

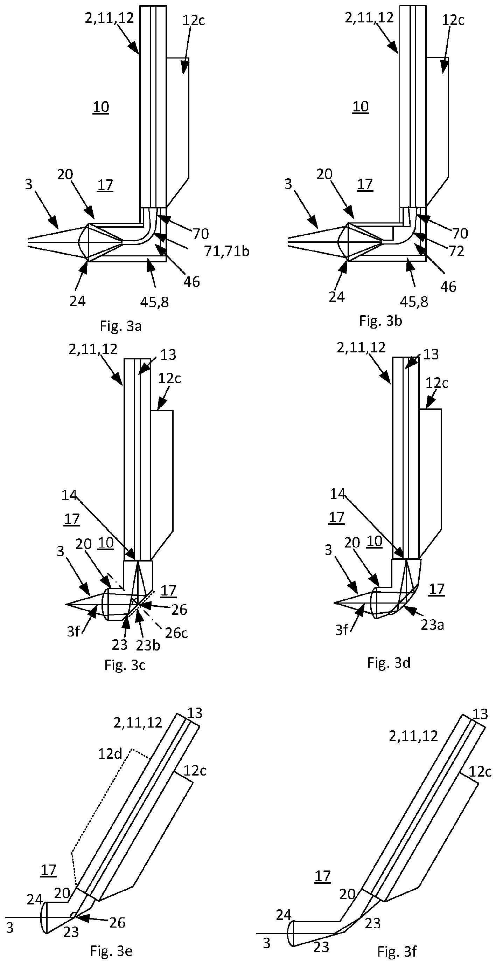

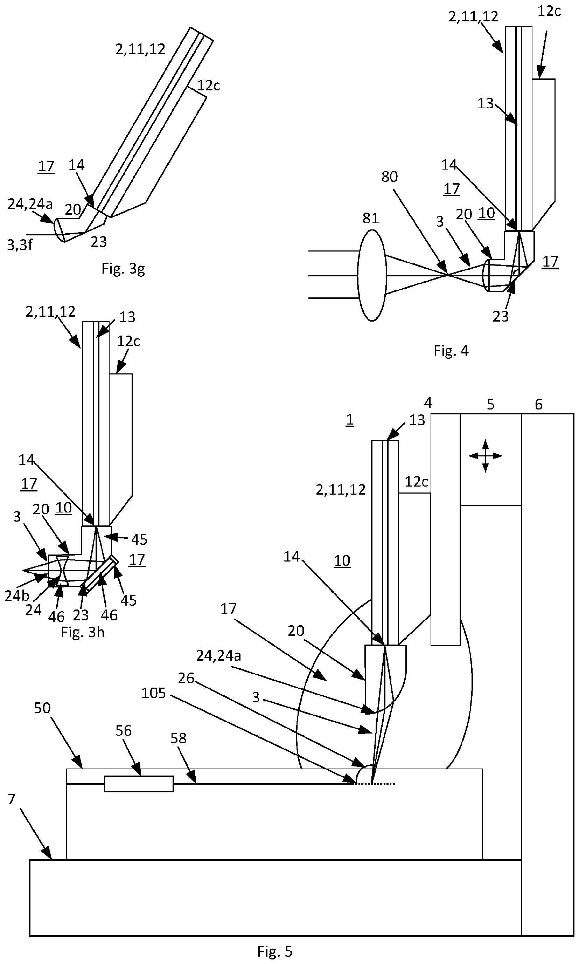

Figure 3 illustrates various exemplary embodiments of the probe head 10, comprising the test component 2, and the micro-optical element 20.

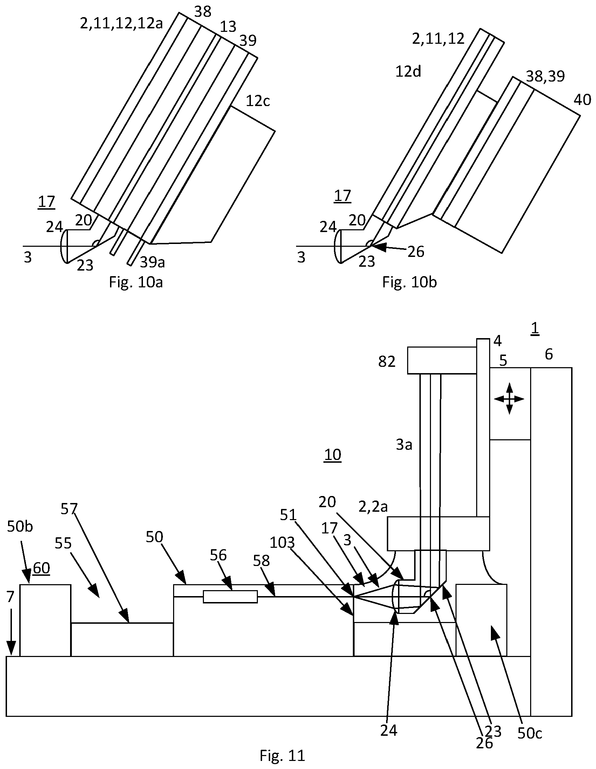

As depicted in Figure 3a, the micro-optical element 20 features a 3D-printed waveguide 71, in particular a photonic wirebond (PWB). The photonic wirebond may be designed such that at least 50 %, preferably at least 90 %, more preferred at least 95 % of the light 3 transmitted by the fiber 12 is redirected in the designed manner, in particular by choosing an appropriate index contrast, curvature radius and waveguide diameter. The waveguide diameter and the refractive index contrast are chosen such that the photonic wirebond is single-mode photonic wirebond, preferably exhibiting a refractive index of 1.4 to 1.63, in particular of 1.53. A preferred resist for the fabrication of the photonic wirebond may comprise a commercial resist from the VanCore series or a similar product. The cavity 46 may, preferably, be filled with the index-matching liquid 17, a specially designed material for the photonic wirebond, e.g. from the VanClad Series, a similar product, or air. The photonic wirebond may further, preferably, be polarization conserving in case the optical fiber 12 may be polarization conserving, or an arrangement according to Fig. 11 may be used. The waveguide 71 may be a multi-mode waveguide, preferably having a gradient index fiber configured to reduce modal dispersion. The mechanical support 8 may be the containment structure 45, or be separate from the containment structure 45. Further, the micro-optical element 20 may be the containment structure 45 itself. A taper 70 may adapt the mode field from the optical fiber 12 to the mode-field of the photonic wirebond, wherein a typical decrease from a first value of 5 $\mu$m to 12$\mu$m to a second value of 1 $\mu$m to 3 $\mu$m may be used for a single-mode operation in the near infrared region having a wavelength of 1 $\mu$m to 2$\mu$m. For other wavelengths the mode-field diameters may scale accordingly to the wavelength. The photonic wirebond may, preferably, have a minimum bending radius of at least 30 $\mu$m, more preferred of at least 60 $\mu$m, in particular of at least 100 $\mu$m. The photonic wirebond may be designed as a waveguide 71b which preserves polarization, e.g. by showing birefringence as being designed to have an elliptic cross-section.

Figure 3b shows a further exemplary embodiment of the test component 2 and the micro-optical element 20, wherein a whispering gallery waveguide 72 is used.

Figure 3c shows a further exemplary embodiment of the test component 2 and the micro-optical element 20, wherein the refractive index between the material of the micro-optical element 20 and the index matching liquid 17 is so high that at the angle 26 total internal reflection does not fail. For the indicated angle 26 of 90°, the angle with respect to a surface normal 26c of a chief ray 3f of the light 3 is 45°. To achieve the desired total internal reflection in this embodiment for the chief ray 3f, the angle of the chief ray 3f with respect to a surface normal may, preferably, be as follows: If the micro-optical element 20 has a refractive index of $n_1 = 1.53$, the index matching liquid 17 must have a refractive index $n_c$ of not more than 1.08. If the micro-optical element 20 has a refractive index of $n_1 = 1.62$, the index matching liquid 17 must have a refractive index $n_c$ of less than 1.14. Alternatively or in addition, the reflecting surface 23 may be coated with a thin film 23b. The thin film may be or comprise metal, especially selected from at least one of Al, Au, Cr, Ni, Ag, or Pt, or a dielectric material. Herein, the term "thin film" means a thickness of the film below the desired wavelength. As an alternative, a thick film of a low-index polymer, preferably fluorinated, may be used. Herein, the term "thick film" means a thickness of the film being larger than an evanescent field of the total internal reflection. The coating may also serve a purpose of altering a wetting behavior. Preferably, a coating may be used that does not change the polarization of the light by using a polarization that is not in the reflection plane of the reflecting surface 23. This means, the phase shift of s- and p-polarized light is essentially identical upon reflection. This may be achieved by tailoring different reflective layers or using metamaterials that reflect without changing the phase depending on polarization direction.

In order to support that at least the light 3 is reflected in that shallower rays may be reflected, while steeper rays may not be reflected at higher refractive index contrasts $n_c$ of the index matching liquid 17 and of the reflecting surface 23, the index matching liquid 17 and the reflecting surface 23 may have an alternative shape, such as the shape of a reflecting surface 23a as depicted in Figure 3d. The advantages thereof may, in particular, be that other rays than the chief ray 3f are reflected up to a lower refractive index contrast $n_c$ and that the focusing properties are independent of the refractive index of the index matching liquid 17.

Alternatively or in addition, the test component 2 may be tilted as shown in Fig 3e by an angle preferably of 0° to 85° in a vertical manner with respect to the surface 50a of the micro-optical component 50 as depicted in Figures 1, 6b, 8 or 9. At shallower angles of 30° or less, the V-Groove array 12c may be in mechanical conflict with 50. To achieve shallower angles of 30° or less, instead using the V-Groove 12c, the V-Groove 12d depicted by the dashed line may be used. In this embodiment, the angle 26 of deflection can be larger, in particular being further away from the critical angle of total internal reflection, while still having an emission of the light 3 essentially in the surface 50a of the micro-optical component 50.

Figure 3f shows a further exemplary embodiment of the test component 2 and the micro-optical element 20, wherein several reflections at several reflective surfaces 23 ensure that the total internal reflection does not fail.

Figure 3g shows a further exemplary embodiment of the test component 2 and the micro-optical element 20, wherein the refractive surface 24 may be designed as a refractive surface 24a, whereby the direction of the chief ray 3f and other rays of the light 3 is changed and at the same time the divergence may be changed. In a particular embodiment, example, the beam of the light 3 may be focused. In an alternative embodiment, the divergence may not be changed and the light 3 is only deflected. Thereby, back reflection at the refractive surface 24 into a fiber core 13 or into the micro-optical component 50 are suppressed. In preferred embodiment, the light 3 may be transmitted at essentially the Brewster angle. In this case, the refractive surface 24 is tilted such that the light 3 hits the refractive surface 24 approximately at the Brewster angle. If this is not possible for all portions of the light 3, a simulation can be performed which may be configured for optimizing the shape of the refractive surface 24 for low back reflection. Additionally, the propagation direction of the light 3 may not be in the plane of the surface 50a of the micro-optical component 50, but may assume a certain angle to the surface 50a of the micro-optical component 50. Also, the surface of the coupling location 14 may be tilted with respect to the propagation direction of the light 3 and thereby change the propagation direction of the light 3 and suppress back-reflection.

Figure 3h shows a further exemplary embodiment of the test component 2 and the micro-optical element 20 having cavities 46, which may, preferably, be filled with air, another gas, vacuum, or a low index polymer, preferably having a lower refractive index than the material of the micro-optical element 20, preferably not more than 1.4, more preferred not more than 1.31, in particular close to 1. One of the cavities 46 acts here as the refractive surface 24, while another of the cavities 46 acts here as the reflective surface 23. In this embodiment, the index matching liquid 17 may have a refractive index comparable to the refractive index of the micro-optical element 20 or higher. In an embodiment, in which the index matching liquid 17 may essentially be index matched to the micro-optical element 20, a refractive surface 24b has no optical functionality. Alternatively, in a case in which the index matching liquid 17 and the micro-optical element 20 may not have the same refractive index, the refractive surface 24b may function in the same manner as the refractive surface 24 and may focus or defocus the light 3. If the refractive indices of the index matching liquid 17 and the micro-optical element 20 are not matched, the refractive surface 24b may be designed such that it is essentially perpendicular to rays of the light 3, tangential to phase fronts of the light 3, or at the Brewster angle to avoid unwanted reflection. If the light 3 is to be emitted essentially co-linear to the fiber core 13, the reflecting surface 23 and the cavity 46 may not be implemented while the probe head 10 may essentially be working like a lens fiber without deflecting light.

Figure 4 illustrates a further exemplary embodiment of the probe head 10 and the micro-optical element 20, more specifically for calibrating, qualifying, analyzing or testing the functionality of the probe head. For this purpose, a high NA objective immersion lens, wherein the numerical aperture (NA) may, preferably, exceed 1.0, more preferred exceed 1.2, may be operated in the index matching liquid 17. Preferably, an objective lens 81 which is configured to be adjustable with respect to the refractive index may be used. The focal plane of the objective lens 81 can, preferably, be aligned to a focus 80. By optionally numerically correcting a finite point-spread function, the mode-field at the focus 80 can be measured. Additionally, the objective lens 81 may be translated in the propagation direction of the light 3, wherein the radiation is captured at defined distances. By numerical calculations, the mode-field can be determined in high precision, e.g. by fitting a Gaussian beam to the captured light distribution or by using iterative Algorithms such as the Gerchberg-Saxton algorithm. In particular, the mode-field diameter, the propagation direction, the $M^2$ value and the free working distance as well as the transmission of the light 3 emitted by the test component 2 through the micro-optical element 20 can be measured and calibrated. Additionally, the objective lens 81 may be displaced by a high precision stage relative to the probe head 10 out of the drawing plane, whereby several micro-optical elements 20 may be characterized. In particular, a pitch of light 3 emitted by different micro-optical elements 20 may be measured. Alternatively, the measurement can also be performed with a far-field analyzing device, such as a scanning slit profiler or goniometer having a photodetector. In this embodiment, the far-field analyzer is, preferably, separated from the index matching liquid 17 by a transparent and planar window. This embodiment can also be used for testing a functionality of the objective lens 81.

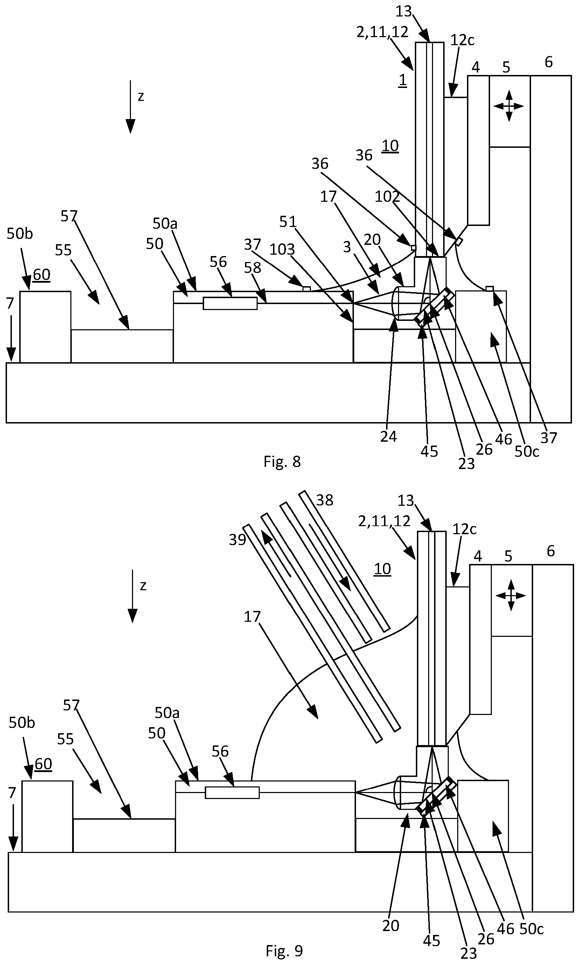

Figure 5 illustrates a further exemplary embodiment of the optical probe 1 configured for the optical testing of the micro-optical component 50. As schematically depicted there, a cladding 17 fully surrounds the micro-optical element 20. As further shown in Figure 5, the optical probe 1 is configured for optically testing of a grating coupler 105, which emits in an angle 26, which may, typically, be 95° to 115°, often 100°. Herein, the refractive surface 24 may be embodied in a manner that it may deflect the light 3 in an angle of 10° from a surface normal to match the emission of the light 3 with the grating coupler 10, particularly to achieve a high optical coupling to the micro-optical component 50. In addition, the angle 26 can be finely adjusted by using a translation stage 5. In a further embodiment, the refractive surface 24 may be an optical lens emitting in a direction along the fiber core 13, while the complete probe head 10 may be tilted by an angle 26 minus 90°, typically between 0 and 20°, preferably 10°, see Figure 8. Such a kind of tilting may, preferably, be implemented by using a part 4b of the fixture 4 and the micro-optical element 20, which is finely adjusted by using the translation stage 5.

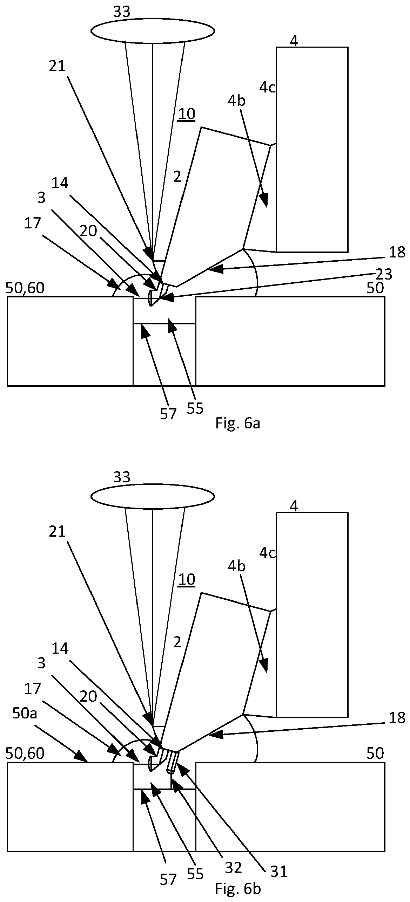

Figure 6a illustrates an exemplary embodiment of the test component 2 and the micro-optical component 50, in particular the wafer 60, wherein a 3D-printed marker element 21 is further used. The marker element 21 may, preferably, be generated in the same printing process as the micro-optical element 20 and may be well aligned, particularly at least to 10 μm, preferably to 5 μm, especially to 1 μm, to both the micro-optical element 20 and the coupling location 14. The marker element 21 may be visible in a field of view of a top-view camera 33, which may for configured to provide a simplified alignment of the probe head 10 to the micro-optical component 50, especially to a wafer 60, and to a trench 55. The position of the marker element 21 may be calibrated with respect to one of the micro-optical component 50, in particular the wafer 60, the focus 80, the top-view camera 33, or a mechanical support 7. To avoid a blocking of a vision of the top-view camera 33 on the marker element 21, the mechanical fixture 4 has a part 4b which may be configured to fix the test component 2 at a certain angle. The angle may, preferably, be 5° to 15° compared to a surface normal of the wafer. To avoid mechanical contact of the test component 2 with the surface of the wafer 60, the exemplary test component 2 as depicted here comprises a chamfer 18. Without the chamfer 18, a mechanical contact could occur at position assumed by the chamfer 18, which would destroy at least a portion of the micro-optical component 50, especially the wafer 60. Furthermore, the micro-optical element 20 is arranged here in a manner that the light 3 is emitted horizontally to the surface of the micro-optical component 50, especially of the wafer 60. This arrangement can be achieved by tilting the reflecting surface 23. The marker element 21 may be sufficiently far away from the index matching liquid 17 and such that the vision of the top-view camera 33 onto the surface of the micro-optical component 50, in particular the wafer 60, is not disturbed. For this purpose, the marker may be displaced out of or into the drawing plane to be far enough away from the index matching liquid 17. This allows precise alignment of the probe head 10 with the micro-optical component 50, in particular the wafer 60, using the marker element 21. Alternatively, the top-view camera 33 may be an immersion objective lens and the index matching liquid 17 may be in contact with the top-view camera 33 and the marker element 21. Typically, at least two marker elements 21 may be used.

Figure 6b illustrates a further exemplary embodiment of the test component 2 and the micro-optical component 50, in particular the wafer 60, wherein a distance sensor 31 is further used. Herein, distance sensor 31 may be configured to measure a distance 32 to a part of the micro-optical component 50, in particular the wafer 60, especially to the surface 50a or a bottom of a deep etch 57 to a mechanical support for the micro-optical component 50, in particular the wafer 60, or to at least one calibration structure within the optical probe 1. The distance sensor 31 may be a micro-optical element, attached to another fiber core and may be designed to be operated in the index matching liquid 17. The distance sensor 31 may generate a mode-field at a surface to be measured with a desirable size. For high spatial resolution measurements, a small size may be preferred. The fiber to which the distance sensor 31 may be connected may lead to an interferometer, such as an optical coherence tomograph or a white light interferometer. The distance sensor 31 may also be constructed to measure the distance 32 based on a chromatic principle. The distance sensor 31 may interact with specifically designed marker structures within the micro-optical component 50, in particular the wafer 60, that may guide the probe head 10 to a desired position, analogue to landing lights guiding a plane to an airport runway. Such marker structures may be constructed as structures creating a highly distinguishable back-reflection signature or signal guiding to the right position, such as retro reflectors, or gratings. The distance sensor 31 may also be selected from an optical sensor, a mechanical sensor, or an electrical sensor, such as a capacitive sensor, including an atomic-force microscope..

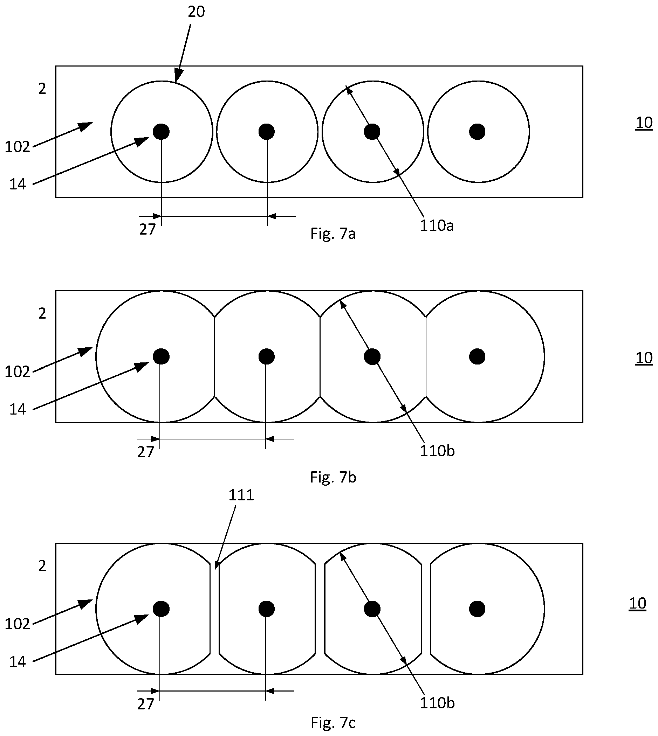

Figure 7 illustrates a facet view directed at a facet 102 of the test component 2 having a plurality of micro-optical elements 20, wherein the coupling locations 14 in adjacent micro-optical elements 20 are separated by a pitch 27. As schematically depicted in Figure 7a, each micro-optical element 20 has a preferable diameter 110a. As schematically depicted in Figure 7b, each micro-optical element 20 has a diameter 110b, wherein adjacent micro-optical elements 20 are intersecting. As schematically depicted in Figure 7c, each micro-optical element 20 has a diameter 110b, wherein adjacent micro-optical elements 20 are separated by leaving a gap 111. The gap 111 may be advantageous for mechanically decoupling the adjacent micro-optical elements 20 which is preferable for a higher reliability of the probe head 10.

Figure 8 illustrates a further exemplary embodiment of the optical probe 1 and the micro-optical component 50 having liquid guarding elements 36, 37 which are configured to limit a spread of the index matching liquid 17. Exemplary implementation of the liquid guarding elements 36, 37 may be selected from at least one of:

- Tips, spikes, gratings, corrugated surface, or a nano-structured surface;
- Surfaces with low surface wetting, e.g. fluorinated surface;
- Gaps, grooves, trenches in particular with suspended membranes; or
- Fences, capillaries controlling liquid.

Figure 9 illustrates a further exemplary embodiment of the optical probe 1 and the micro-optical component 50 having a dispense nozzle 38 and a remove nozzle 39, which are configured to dispense or remove the index matching liquid 17, respectively. Additional nozzles or the same nozzles may, further, be used to dispense cleaning liquid to remove the index matching liquid 17, to blow dry, e.g. with gaseous nitrogen, or ink-jet print heads to locally dispense the index matching liquid 17. Alternatively, or in addition, devices configured to heat and evaporate the index matching liquid 17 may be used. As a further alternative or still in addition, a critical point dryer or further devices configured to spin the wafer 60 or a disc on which the micro-optical component 50 may be fixed can be used to remove the index matching liquid 17. The nozzles may be fixed on a translation stage, such as the translation stage 5, or may remain stationary, or may be attached to the mechanical support 7, whereas the mechanical support 7 may be movable with respect to the probe head 10.

Figure 10a illustrates a further exemplary embodiment of the test element 2 and the micro-optical element 20, wherein the dispense nozzle 38 and the remove nozzle 39 are embodied as channels of a hollow core fiber. Herein, the optical fiber 12 is embodied as a hollow core fiber or as fiber bundles having two hollow core fibers configured for dispensing and removal of the index matching liquid 17, respectively, and, furthermore, having the fiber core 13 configured for transmitting light. At least one of the dispense nozzle 38 or the remove nozzle 39 may comprise at least one 3D-printed extension, which may, preferably, be fabricated in the same fabrication step as the micro-optical element 20. The dispense nozzle 38 and/or the remove nozzle 39 comprising at least one extension can be configured to ensure that the index matching liquid 17 may, preferably, be removed to a large fraction, or to clean the reflecting surface 23.

Figure 10b illustrates a further exemplary embodiment of the test element 2 and the micro-optical element 20, wherein the dispense nozzle 38 and the remove nozzle 39 are embodied as part of a microfluidic chip 40, which may be fixed to the probe head 10, or may be movable with respect to the probe head 10.

Figure 11 illustrates a further exemplary embodiment of the optical probe 1, wherein the test component 2 comprises a transparent substrate 2a. Herein, the transparent substrate 2a has an essentially planar window through which light 3a can travel from the micro-optical element 20 to a free space imaging and testing device 82 and vice versa, or in both directions. The imaging device may be or comprise microscope waveguide components, such as fibers in an intermediate imaging plane. The imaging device may couple light into the coupling location 51 of the micro-optical component 50 or receive light from the coupling location 51 of the micro-optical component 50.

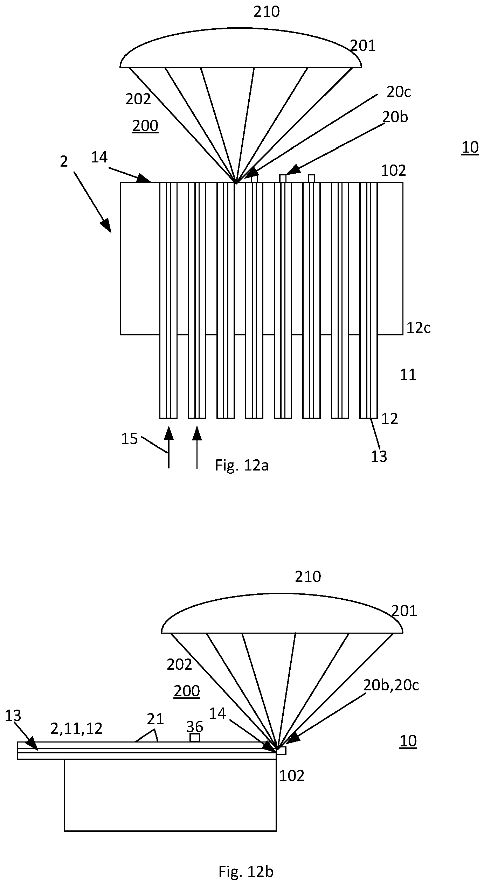

Figure 12a illustrates an exemplary embodiment of a method for producing the probe head 10. An objective lens 201 generates a laser beam 202 configured for curing a photoresist 200. As an alternative, a solubility of the photoresist 200 may be changed by irradiation of the laser beam 202. By scanning the laser beam 202 in three dimensions, structures 20b in the micro-optical element 20 to be fabricated are generated. For aligning a structure 20c in the micro-optical element 20 to be fabricated to the coupling location 14, light 15 may be coupled into the test component 2. The light 15 is selected in a manner that it may be transmitted by optical waveguides 25. The lithography system 210 has a detector configured to detect the position of the light 15 exciting the test component 2 through the coupling locations 14. The detector may be a CCD camera, or a confocal detector. Alternatively, the laser beam 202 can be coupled to the probe head 10 through the coupling locations 14 and may be detected at the fiber core 13, or by a detector within the test component 2 coupled to the probe head 10. As a further alternative, a feature within the test component 2, especially the optical waveguide 25 or the marker element 21 (not depicted here), may be used for alignment. For this purpose, light of the laser beam 202 coupling into the fiber core 13 and being reflected at a feature within the optical waveguide 25, such as the facet 104 or at the fiber core 13, may be detected. After irradiation, the liquid photoresist 200 is removed, preferably by using a solvent.

Figure 12b illustrates a further exemplary embodiment of the method for producing the probe head 10. Herein, the probe head 10 is positioned, such that the lithography system 210 views the fiber cores from the side. This allows fabricating the liquid guarding elements 36 and the marker element 21 relatively far away from the coupling location 14 of the test component, preferably by a distance of at least 200 μm, more preferred of at least 500 μm, in particular of at least 1000 μm; however, using a larger distance may also be feasible.

List of Reference Signs

| | |
|---|---|
| 1, 1b | Optical probe |
| 2 | Test component |
| 2a | Transparent substrate of test component |
| 3,3a | Light coupled between test component and micro-optical component |
| 3f | Chief ray |
| 4 | Fixture for test component |
| 4b | Part of fixture for test component configured for mounting test component at an angle compared to being directly mounted on the surface |
| 4c | Surface, being part of the fixture for test component essentially vertical to the surface of wafer |
| 5 | Translation stage, typically 6 degrees of freedom |
| 6 | Mechanical support, carrier |
| 7 | Mechanical support for micro-optical component and wafer, chuck |
| 8 | Mechanical support, being part of micro-optical element |
| 10 | Probe head |
| 11 | Fiber array |
| 12 | Optical fiber |
| 12a | Hollow-core fiber |
| 12c, 12d | Glass block having at least one V-Groove |
| 13 | Fiber core |
| 14 | Coupling location of test component |
| 15 | Light coupled into probe head |
| 16 | Second probe head |
| 17 | Index matching liquid |
| 18 | Chamfer in test component |
| 20 | Micro-optical element |
| 20b, 20c | Structure in micro-optical element to be fabricated |
| 21 | (3D-printed) Marker element |
| 23 | Reflecting surface, e.g. a total-internal reflection mirror |
| 23a | Reflecting surface, having an alternative shape |
| 23b | Thin film, coating the reflecting surface |
| 24 | Refractive surface, e.g. an optical lens or a prism |
| 24a | Refractive surface changing the propagation direction of the light, in particular of the chief ray |
| 24b | Refractive surface reducing divergence of light coupled between test component and micro-optical component |
| 25 | Optical waveguide, being part of test component |
| 26 | Angle |
| 26c | Surface normal |
| 27 | Pitch of coupling location of test component at facet of test component |
| 31 | Distance sensor |
| 32 | Distance between distance sensor and surface of wafer |
| 33 | Top-view camera |
| 34 | Free working distance |
| 35 | Vacuum tool or permanent fixture |
| 36 | Liquid guarding element, being part of the probe head |
| 37 | Liquid guarding element, being part of the micro-optical component |
| 38 | Liquid dispensing element, e.g. a dispense nozzle |
| 39 | Liquid removal element, e.g. a remove nozzle |
| 40 | Microfluidic chip |
| 45 | Containment structure |
| 46 | Cavity |
| 50, 50c | Micro-optical component |
| 50a, 50b | Surface of micro-optical component |
| 51 | Coupling location of micro-optical component |
| 55 | Trench etched into wafer |
| 56 | Functional element, being part of micro-optical component, e.g. waveguide, laser or photodiode |
| 57 | Bottom of deep etch |
| 58 | Waveguide, being part of micro-optical component |
| 60 | Wafer |
| 70 | Taper |
| 71 | Waveguide |

| | |
|---|---|
| 71b | Waveguide configured to preserve a polarization of light |
| 72 | Whispering gallery waveguide |
| 80 | Focus |
| 81 | Objective lens |
| 82 | Free space imaging and testing device |
| 102 | Facet of test component configured for attaching micro-optical element |
| 103 | Facet of micro-optical component |
| 105 | Grating coupler |
| 110a | Diameter of a micro-optical element, being smaller or equal than pitch of coupling location of test component at facet of test component |
| 110b | Diameter of a micro-optical element, being larger than pitch of coupling location of test component at facet of test component |
| 111 | Gap between micro-optical elements having diameter 110b |
| 200 | (Liquid) photoresist |
| 201 | Objective lens for fabrication of micro-optical elements |
| 202 | Laser beam of objective lens |
| 210 | Lithography system |

**Claims**

1. An optical probe (1) configured for optical testing of at least one micro-optical component (50), comprising,

    - a probe head (10), wherein the probe head (10) comprises a test component (2);
    - at least one micro-optical element (20), wherein the micro-optical element (20) is a separate element with regard to the test component (2) and in mechanical contact with the test component (2),

    wherein the micro-optical element (20) is configured to optically couple light (3) between the test component (2) and the micro-optical component (50), thereby being configured to determine an optical performance of the micro-optical component (50), and wherein the micro-optical element (20) is configured to be operated in an index matching liquid (17).

2. The optical probe (1) according to the preceding claim, further configured to operate the index-matching liquid (17) by having at least one of:

    - a liquid dispensing element (38), wherein the liquid dispensing element (38) is configured to dispense at least one portion of the index matching liquid (17);
    - a hollow-core fiber (12a), wherein the hollow-core fiber (12a) is configured to receive the at least one portion of the index matching liquid (17);

    - a liquid guarding element (36), wherein the liquid guarding element (36) is configured to control a spread of the at least one portion of the index matching liquid (17);
    - a liquid removal element (39), wherein the liquid removal element (39) is configured to remove the at least one portion of the index matching liquid (17);
    - a microfluidic chip (40).

3. The optical probe (1) according to any one of the preceding claims, wherein the micro-optical element (20) has at least one of:

    - a cavity (46);
    - a waveguide (71);
    - a reflecting surface (23), wherein the reflecting surface (23) is configured to deflect the light (3) by at least 10°, or wherein at least at two reflecting surfaces (23) are configured to reflected the light (3);
    - a refractive surface (24); wherein the refractive surface (24) is configured to deflect the light (3) by at least 2°;
    - a functional surface configured to alter at least one of a refractive property or a wetting property;
    - at least one high-index material, wherein the high-index material has a refractive index of at least 1.6.

4. The optical probe (1) according to any one of the preceding claims, wherein the micro-optical element (20) comprises at least one optical fiber (12), wherein the optical fiber (12) is tilted at an angle of at least 5° with respect to a surface normal of the micro-optical component (50).

5. The optical probe (1) according to any one of the preceding claims, wherein the optical probe (1) is configured for coupling at at least two coupling locations (51) of the micro-optical component (50).

6. The optical probe (1) according to any one of the preceding claims, wherein the micro-optical element (20) meets at least one accuracy selected from at least one of:

    - a shape accuracy of the micro-optical element (20) is at least 250 nm;
    - an alignment accuracy of the micro-optical element (20) with respect to a coupling location (14) of the of test component (2) is at least 1000 nm;
    - a pitch accuracy between two micro-optical elements (20) is at least 1000 nm;
    - a mode-field accuracy of at least 10 %.

7. The optical probe (1) according to the preceding claim, wherein the optical performance of the probe head (10) is calibrated.

8. The optical probe (1) according to any one of the preceding claims, wherein at least one of the probe head (10) or the micro-optical component (50) comprises at least one marker element (21), wherein the marker element (21) is configured for an alignment of the probe head (10) with respect to the micro-optical component (50).

9. The optical probe (1) according to any one of the preceding claims, wherein the test component (2) comprises at least one of

    - a fiber array (11);
    - a transparent substrate (2a).

10. A use of an optical probe (1) according to any one of the preceding claims, wherein the optical probe (1) is configured for optical testing of a micro-optical component (50), wherein the micro-optical component (50) comprises at least one of:

    - a liquid guarding element (37);
    - a structure configured to be operated in the index-matching liquid (17), wherein the structure is, particularly, selected from an optical structure, a mechanical structure or an optomechanical structure;
    - a metamaterial taper configured to be operated in the index-matching liquid (17), wherein the taper is, particularly, selected from a metamaterial taper, a suspended taper or an adiabatic taper; and/or

    wherein the micro-optical component (50) is configured for being operated in a liquid cryogenic environment.

11. A method for producing an optical probe (1) configured for optical testing of at least one micro-optical component (50), in particular the optical probe (1) according to any one of the preceding claims referring to the optical probe (1), the method comprising the following steps:

    (i) providing a probe head (10), wherein the probe head (10) comprises a test component (2); and
    (ii) generating at least one micro-optical element (20) by using a direct-write process, wherein the micro-optical element (20) is being generated as a separate element with regard to the test component (2) and in mechanical contact with the test component (2),

    wherein the micro-optical element (20) is configured to optically couple light (3) between the test component (2) and a micro-optical component (50), thereby being configured to determine an optical performance of the micro-optical component (50) and wherein the micro-optical element (20) is configured to be operated in an index matching liquid (17).

12. The method according to the preceding claim, further comprising at least one of the following steps:

    (iii) applying an adhesion promoter to the test component (2) prior to step (ii);
    (iv) mounting the at least one micro-optical element (20) on a support (4) prior to step (ii).

13. The method according to any one of the two preceding claims, wherein the micro-optical element (20) is generated during step (ii) by using by an additive manufacturing method.

14. A method for optical testing of at least one micro-optical component (50), the method comprising the following steps:

    a) providing an optical probe (1), wherein the optical probe (1) comprises a probe head (10) and at least one micro-optical element (20), wherein the probe head (10) comprises a test component (2), wherein the micro-optical element (20) is a separate element with regard to the test component (2) and in mechanical contact with the test component (2); and
    b) positioning the probe head (10) in a manner that the micro-optical element (20) optically couples light (3) between the test component (2) and the micro-optical component (50), wherein the light (3) at least partially propagates through an index matching liquid (17), wherein the index matching liquid (17) is at least partially in contact with the at least one micro-optical component (20); and
    c) determining an optical performance of the micro-optical component (50) by measuring an optical signal being indicative for the optical performance of the micro-optical component (50).

15. The method according to the preceding claim, further comprising at least one of the following steps:

    d) calibrating the optical performance of the probe head (10) prior to step b);
    e) inserting at least one portion of the micro-optical element (20) into a trench (55), wherein the trench (55) is comprised by the micro-optical component (50) in a manner that the light (3) is optically coupled between the test component (2) and the micro-optical component (50) during step b).

f) dispensing the index matching liquid (17) prior to or during step b);

g) removing the index matching liquid (17) during or after step b) or step c);

h) determining the optical performance of the micro-optical component (50) during step c) prior to, under, or after an application of the index matching liquid (17);

i) altering a temperature of the micro-optical component (50) or a surface (50a) thereof at least during step c);

j) treating the optical probe (1) in a critical point dryer at least during step c);

k) operating the optical probe (1) by using a broadband light source having a linewidth of at least 5 nm at least during step c).

Fig. 1

Fig. 2

Fig. 3a

Fig. 3b

Fig. 3c

Fig. 3d

Fig. 3e

Fig. 3f

Fig. 3g

Fig. 4

Fig. 3h

Fig. 5

Fig. 6a

Fig. 6b

20

2

102

14

27

10

110a

Fig. 7a

2

102

14

27

10

110b

Fig. 7b

111

2

102

14

27

10

110b

Fig. 7c

Fig. 8

Fig. 9

Fig. 10a

Fig. 10b

Fig. 11

Fig. 12a

Fig. 12b

# EP 4 621 457 A1

Europäisches
Patentamt

European
Patent Office

Office européen
des brevets

## EUROPEAN SEARCH REPORT

**Application Number**

EP 24 16 4535

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | NORIKI AKIHIRO ET AL: "45-degree curved micro-mirror for vertical optical I/O of silicon photonics chip", OPTICS EXPRESS, vol. 27, no. 14, 8 July 2019 (2019-07-08), page 19749, XP055829053, US ISSN: 2161-2072, DOI: 10.1364/OE.27.019749 * page 19750; figures 1, 3, 7 * | 1-15 | INV. G02B6/26 G01M11/00 |
| A | EP 1 712 942 A1 (INFINEON TECHNOLOGIES FIBER OP [DE]) 18 October 2006 (2006-10-18) * paragraph [0021] * * paragraph [0028] * * paragraph [0033] - paragraph [0034] * * paragraph [0048] * * figures 1-5 * | 1-15 | |
| A | US 2023/258871 A1 (ROBBINS MATTHEW [US] ET AL) 17 August 2023 (2023-08-17) * abstract; figures 1-4 * | 1-15 | TECHNICAL FIELDS SEARCHED (IPC) G01M G02B |
| A | US 2004/081401 A1 (THOMA PETER [DE] ET AL) 29 April 2004 (2004-04-29) * abstract * * paragraph [0003] * * paragraph [0006] * | 1-15 | |

The present search report has been drawn up for all claims

| Place of search | Date of completion of the search | Examiner |
|---|---|---|
| The Hague | 9 September 2024 | Mouget, Mathilde |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 621 457 A1**

## ANNEX TO THE EUROPEAN SEARCH REPORT
## ON EUROPEAN PATENT APPLICATION NO.

EP 24 16 4535

This annex lists the patent family members relating to the patent documents cited in the above-mentioned European search report.
The members are as contained in the European Patent Office EDP file on
The European Patent Office is in no way liable for these particulars which are merely given for the purpose of information.

09-09-2024

| Patent document cited in search report | | Publication date | Patent family member(s) | | Publication date |
|---|---|---|---|---|---|
| EP 1712942 | A1 | 18-10-2006 | NONE | | |
| US 2023258871 | A1 | 17-08-2023 | CN | 116643356 A | 25-08-2023 |
| | | | EP | 4231070 A1 | 23-08-2023 |
| | | | US | 2023258871 A1 | 17-08-2023 |
| US 2004081401 | A1 | 29-04-2004 | DE | 60203037 T2 | 21-07-2005 |
| | | | EP | 1329752 A1 | 23-07-2003 |
| | | | US | 2004081401 A1 | 29-04-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018083191 A1

- US 6925238 B2

**Non-patent literature cited in the description**

- **TRAPPEN M. et al.** 3D-printed optical probes for wafer-level testing of photonic integrated circuits. *Optics Express*, 2020, vol. 28, 37996-38007
- **QU et al.** Experiments on Metamaterials with Negative Effective Static Compressibility. *Phys. Rev. X*, 2017, vol. 7, 041060

- **PENG et al.** CMOS Compatible Monolithic Fiber Attach Solution with Reliable Performance and Self-alignment. *OFC, Th*, 2022, vol. 3 (1), 4